# EUROPEAN PATENT SPECIFICATION

(11) **EP 2 814 237 B1**
(45) Date of publication and mention of the grant of the patent: **06.03.2019**
(21) Application number: 13746822.9
(22) Date of filing: 29.01.2013
(51) Int. Cl.: H04N 5/225, H04N 5/345, H04N 5/374

(54) **IMAGE OUTPUT METHOD AND IMAGE OUTPUT APPARATUS**
BILDAUSGABEVERFARHEN UND BILDAUSGABEVORRICHTUNG
PROCÉDÉ DE LECTURE D'IMAGES ET APPAREIL DE LECTURE D'IMAGES

(30) Priority: 08.02.2012 JP 2012024829
(43) Date of publication of application: 17.12.2014
(73) Proprietor: FUJI Corporation, Chiryu Aichi (JP)
(72) Inventor: HIRANO, Atsunori, Chiryu Aichi (JP); HIROTA, Shigemoto, Chiryu Aichi (JP); YAMASHITA Yasuhiro, Chiryu Aichi (JP); NAGASAKA Nobuo, Chiryu Aichi (JP); JINDO Takahiro, Chiryu Aichi (JP)
(74) Representative: Grünecker Patent- und Rechtsanwälte PartG mbB
(86) International application number: PCT/JP2013/051863
(87) International publication number: WO 2013/118610

(56) References cited:
- JP-A- 2004 023 256
- JP-A- 2004 038 841
- JP-A- 2004 038 841
- JP-A- 2006 109 001
- JP-A- 2008 048 191

## Description

### Technical Field

The invention relates to an image transmission method and an image transmission apparatus capable of transmitting image data from an image sensor, and more specifically to a method and an apparatus capable of transmitting image data of an interest region which is set in an imaging region.

### Background Art

As board production apparatuses which produce a board mounted with a plurality of electronic components, there are a solder printing apparatus, a component mounting apparatus, a reflow apparatus, a board inspection apparatus, and the like. The apparatuses are often connected to each other via a board transport apparatus so as to build a board production line. A large number of board production apparatuses are provided with cameras in order to recognize various marks or codes added to boards or inspect states of boards or components. Generally, the camera is provided with an image sensor which includes imaging elements (pixel array) arranged in a two-dimensional manner and converts pixel data of each imaging element into digital data which is output, so as to transmit an image at a high speed. Particularly, since, in the board production line, circumstances of a captured image are determined, and process content performed on a board next is changed, fast transmission of an image is an important factor of improving production efficiency. In addition, since image data of an entire imaging region of the camera is not necessary in most cases, a trial is conducted to set an interest region so that only some image data is transmitted, thereby reducing an amount of transmitted data so as to achieve higher speed.

PTL 1 discloses a technique example of an imaging apparatus (camera) in which such an interest region is set and image data is output. The imaging apparatus of PTL 1 includes a self-information storage part which stores a region number of set regions (interest regions), a use region setting part which stores region information for setting a region to be used, first and second response means for changing/correcting the region information in response to an instruction from an external device, and means for outputting image data set in the region information on the basis of a standard of Institute of Electrical and Electronics Engineers (IEEE). In addition, various means using packet communication are disclosed as specific means in claim 2 and subsequent claims. It is disclosed that, with this configuration, a plurality of regions for imaging a subject are provided, and convenience can be improved.

### Citation List

### Patent Literature

PTL 1: JP-A-2006-109001

### Summary of Invention

### Technical Problem

However, according to the imaging apparatus of PTL 1, image data of a partial region in an imaging region can be output in the unit of packets, but cannot be output in the unit lower than packets. Therefore, a region cannot be set in the unit lower than packets, and thus operability deteriorates (not convenient) when desired any interest region is set. In addition, time is taken since image data which are output in the unit of packets are temporarily stored in a storage device, and is then required to be converted into image data of an interest region. For this reason, production efficiency is not improved in a board production line using the imaging apparatus of PTL 1.

In addition, PTL 1 does not disclose a specific output method in a case where a plurality of interest regions overlap each other. Typically, a CMOS element, a CCD element, or the like is used as an imaging element, and if pixel data is output once, the pixel data vanishes. Therefore, if pixel data items of two overlapping interest regions are output separately, the pixel data of an overlapping part in the interest region which is output later has already vanished, and thus an accurate image cannot be obtained. In addition, even if the imaging apparatus can perform outputting twice or more, it is not efficient to output an overlapping part twice, and accordingly time required for the output increases.

The document JP 2008-048191 A discloses a fixed pattern noise removing device and imaging apparatus comprising an image sensor collecting a plurality of pixel data items. To the image sensor a fixed pattern noise stripper is connected comprising a changeover section, a line memory, a correction data calculation part and a subtraction part. The changeover section switches the output destination change according to the instructions from a control part and sets it as the line memory or the subtraction part. From a valid pixel area a partial area is selected. A head part of the partial area is selected. The line memory memorizes the horizontal lines of the appointed areas (head parts) and carries out an averaging processing of two or more lines. The correction data calculation part outputs the correction data of one line obtained by averaging processing to the subtraction part and stores it in the memory of the subtraction part. The subtraction part carries out a correction of the partial area by use of the head part.

The invention has been made in consideration of the problem of the background art, and an object thereof is to provide an image transmission method and an image transmission apparatus capable of setting any interest region serving as a transmission target in an imaging region of an image sensor, and reducing required
transmission time since the method and the apparatus are also suitable for a case where a plurality of interest regions overlap each other.
This object is solved by the features of claims 1 and 6.
Further improvements are laid down in the sub-claims.

### Solution to Problem

The invention of an image transmission method according to claim 1 for solving the problem described above is directed to an image transmission method from an image sensor which captures an image of an imaging region of a subject by using a plurality of imaging elements, collects a fixed number of pixel data obtained by the respective imaging elements into a data block, and outputs the pixel data for each data block, the method including a transmission region setting step of setting an interest region which is a transmission target in the imaging region by using a unit lower than the fixed number; a region extension step of extending the interest region so as to obtain an extension interest region in which the data block is represented as a unit, and obtaining extension ranges from the interest region to the extension interest region; an imaging step of performing imaging with the image sensor, obtaining the pixel data by using the respective imaging elements which capture an image of the imaging region, and collecting pixel data
included in the extension interest region into the data blocks; an output step of outputting the data block included in the extension interest region from the image sensor; and an extension range erasing step of erasing pixel data of the extension ranges from the output data block so as to obtain an image of the interest region.

The invention according to claim 2 is directed to the image transmission method according to claim 1, further includes a region optimization step of converting a plurality of extension interest regions into non-overlapping regions which do not overlap each other, subsequently to the region extension step, when a plurality of interest regions are set in the transmission region setting step, and some of the plurality of extension interest regions obtained in the region extension step overlap each other, in which, in the output step, data blocks included in the non-overlapping regions are output instead of the extension interest regions.

The invention according to claim 3 is directed to the image transmission method according to claim 1, in which in the image sensor, the plurality of imaging elements are arranged in a two-dimensional manner such that a plurality of imaging elements are linearly arranged
in an X axis direction on X-Y orthogonal coordinate axes and a plurality of imaging element rows are arranged in a Y axis direction, the plurality of imaging elements which are linearly arranged in the X axis direction are subdivided every fixed number so as to form a block element group, and pixel data of the block element group is set as the data block. In addition, in the transmission region setting step, a rectangular interest region parallel to an X axis and a Y axis is set; in the region extension step, the rectangular interest region is extended to the X axis direction so that a rectangular extension interest region is obtained; and, in the output step, a Y axis coordinate value of an imaging element which is an output target is initially fixed to a minimum value of the extension interest region, an X axis coordinate value is changed from one of the minimum value and a maximum value of the extension interest region to the other value so that a data block of a first row is output, then a Y axis coordinate value of an imaging element which is the output target is increased by one imaging element so as to be fixed, an X axis coordinate value is changed from one of the minimum value and the maximum value of the extension interest region to the other value so that a data block of a second row is output, and a data block of each row is repeatedly output until a Y axis coordinate value of an imaging element which is the output target becomes a maximum value of the extension interest region so that all data blocks included in the rectangular extension interest region are output.

The invention according to claim 4 is directed to the image transmission method according to claim 3, further including a region optimization step of converting a plurality of rectangular extension interest regions into rectangular non-overlapping regions which do not overlap each other and are not continuously located in the X axis direction, subsequently to the region extension step, when a plurality of rectangular interest regions are set in the transmission region setting step, and some of the plurality of rectangular extension interest regions obtained in the region extension step overlap each other, in which, in the output step, all data blocks included in the rectangular non-overlapping regions are output instead of the rectangular extension interest regions.

The invention according to claim 5 is directed to the image transmission method according to claim 4, in which the region optimization step includes a region subdivision sub-step of subdividing the imaging region into a plurality of small regions with a lattice shape by using all X axis coordinate values and Y axis coordinate values indicating boundaries of the plurality of rectangular extension interest regions; a region sorting sub-step of sorting each of the small regions into a necessary small region inside the extension interest region and an unnecessary small region outside the extension interest region; an X axis direction connection sub-step of connecting a plurality of necessary small regions which are continuously located in the X axis direction so as to replace the plurality of necessary small regions with new necessary small regions; a Y axis direction connection sub-step of connecting a plurality of necessary small regions which are continuously located in the Y axis direction and have the same X axis coordinate values indicating the boundaries so as to replace the plurality of necessary small regions with new necessary small regions; and a region fixation sub-step of using the necessary small regions obtained after the X axis direction connection sub-step and the Y axis direction connection sub-step are finished, as the rectangular non-overlapping regions.

The invention of an image transmission apparatus according to claim 6 for solving the problem described above includes an image sensor that captures an image of
an imaging region of a subject by using a plurality of imaging elements, collects a fixed number of pixel data obtained by the respective imaging elements into a data block, and outputs the pixel data for each data block; transmission region setting means for setting an interest region which is a transmission target in the imaging region by using the unit lower than the fixed number in relation to the pixel data obtained by the plurality of imaging elements which capture an image of the imaging region; region extension means for extending the interest region so as to obtain an extension interest region in which the data block is represented as a unit, and obtaining extension ranges from the interest region to the extension interest region; output means for outputting the data block included in the extension interest region from the image sensor; and extension region erasing means for erasing pixel data of the extension ranges from the output data block so as to obtain an image of the interest region.

The invention according to claim 7 is directed to the image transmission apparatus according to claim 6, further including region optimization means, operated subsequently to the region extension means, for converting a plurality of extension interest regions into non-overlapping regions which do not overlap each other, when a plurality of interest regions are set by the transmission region setting means, and some of the plurality of extension interest regions obtained by the region extension means overlap each other, in which the output means outputs data blocks included in the non-overlapping regions instead of the extension interest regions.

The invention according to claim 8 is directed to the image transmission apparatus according to claim 6, in which the image sensor includes the plurality of imaging elements that are arranged in a two-dimensional manner such that a plurality of imaging elements are linearly arranged in an X axis direction on X-Y orthogonal coordinate axes and a plurality of imaging element rows are arranged in a Y axis direction; a multiplexer that changes and selects block element groups obtained by dividing the plurality of imaging elements which are linearly arranged in the X axis direction in a unit of the fixed number; and AD converters, with the same number as the fixed number, that digitalize pixel data of each image element of a block element group selected by the multiplexer. In addition, the transmission region setting means sets a rectangular interest region parallel to an X axis and a Y axis, the region extension means extends the rectangular interest region to the X axis direction so as to obtain a rectangular extension interest region, and the output means fixes a Y axis coordinate value of an imaging element which is an initial output target to a minimum value of the extension interest region, digitalizes and outputs pixel data of each image element of a block element group of a first row by using the AD converter, increases and fixes a Y axis coordinate value of an imaging element which is the next output target by one imaging element to a certain value, digitalizes and outputs pixel data of each image element of a block element group of a second row by using the AD converter, and repeatedly outputs pixel data of each image element of a block element group of each row until a Y axis coordinate value of an imaging element which is the output target becomes a maximum value of the extension interest region so that all data blocks included in the rectangular extension interest region are output.

The invention according to claim 9 is directed to the image transmission apparatus according to claim 8, further including region optimization means, operated subsequently to the region extension means, for converting a plurality of rectangular extension interest regions into rectangular non-overlapping regions which do not overlap each other and are not continuously located in the X axis direction, when a plurality of rectangular interest regions are set by the transmission region setting means, and some of the plurality of rectangular extension interest regions obtained by the region extension means overlap each other, in which the output means outputs all data blocks included in the rectangular non-overlapping regions instead of the rectangular extension interest regions.

The invention according to claim 10 is directed to the image transmission apparatus according to any one of claims 6 to 9, in which the extension region erasing means is formed by using a field programmable gate array.

### Advantageous Effects of Invention

In the invention of the image transmission method according to claim 1, an interest region can be set by using a unit lower than a fixed number. At this time, extension interest regions are obtained, data blocks included in the extension interest regions are output from the image sensor, and pixel data of the extension ranges are erased from the output data blocks so that an
image of the interest region can be obtained. Therefore, any interest region can be set without being aware of the fixed number of data blocks. In addition, an output data block is regarded as the required minimum, and thus required transmission time can be further reduced than in a case where pixel data of an entire imaging region is transmitted.

In the invention according to claim 2, some of a plurality of extension interest regions which overlap each other are converted into non-overlapping regions which do not overlap each other, and data blocks included in the non-overlapping regions are output. Therefore, proper data blocks for the plurality of extension interest regions are output, and thus it is possible to obtain correct images of a plurality of interest regions and also to reduce required transmission time.

In the invention according to claim 3, the image sensor having a plurality of imaging elements arranged in a two-dimensional manner on the X-Y orthogonal coordinate axes, sets a rectangular interest region, obtains an extension interest region to which the interest region is extended in the X axis direction, and outputs all data blocks included in the extension interest region. Therefore, any rectangular interest region can be set in a practical orthogonal two-dimensional imaging region, and pixel data of a required minimum data block is transmitted. Therefore, it is possible to reduce required transmission time, and a practical effect is considerable.

In the invention according to claim 4, a plurality of rectangular interest regions which overlap each other in a practical orthogonal two-dimensional imaging region are converted into rectangular non-overlapping regions which do not overlap each other, and data blocks included in the non-overlapping regions are output. Therefore, a proper data block is output so that correct images of a plurality of interest regions can be obtained. In addition, required transmission time can be reduced, and thus a practical effect is considerable.

In the invention according to claim 5, the region optimization step includes the five sub-steps, and a plurality of rectangular extension interest regions which overlap each other are converted into rectangular non-overlapping regions which do not overlap each other and are not continuously located in the X axis direction. Since the number of non-overlapping regions obtained in this way is minimized and optimized, a data block can be output without unnecessarily subdividing a region, and thus transmission control can be simplified and required transmission time can be reduced.

In the invention of the image transmission apparatus according to claim 6, the image transmission apparatus is constituted by the image sensor, the transmission region setting unit, the region extension unit, the output unit, and the extension region erasing unit. Therefore, an interest region can be set by using a unit lower than a fixed number. At this time, extension interest regions are obtained, data blocks included in the extension interest regions are output from the image sensor, and pixel data of the extension ranges are erased from the output data blocks so that an image of the interest region can be obtained. Therefore, any interest region can be set without being aware of the fixed number of data blocks. In addition, an output data block is regarded as the required minimum, and thus required transmission time can be further reduced than in a case where pixel data of an entire imaging region is transmitted. The invention can be implemented not only as a method but also as an apparatus.

In the invention according to claim 7, some of a
plurality of extension interest regions which overlap each other are converted into non-overlapping regions which do not overlap each other, and data blocks included in the non-overlapping regions are output. Therefore, proper data blocks for the plurality of extension interest regions are output, and thus it is possible to obtain correct images of a plurality of interest regions and also to reduce required transmission time.

In the invention according to claim 8, the image sensor has a plurality of imaging elements arranged in a two-dimensional manner on the X-Y orthogonal coordinate axes, sets a rectangular interest region, obtains an extension interest region to which the interest region is extended in the X axis direction, and outputs all data blocks included in the extension interest region. Therefore, any rectangular interest region can be set in a practical orthogonal two-dimensional imaging region, and pixel data of a required minimum data block is transmitted. Therefore, it is possible to reduce required transmission time, and a practical effect is considerable.

In the invention according to claim 9, a plurality of rectangular interest regions which overlap each other in a practical orthogonal two-dimensional imaging region are converted into rectangular non-overlapping regions which do not overlap each other, and data blocks included in the non-overlapping regions are output. Therefore, a proper data block is output so that correct images of a plurality of interest regions can be obtained. In addition, required transmission time can be reduced, and thus a practical effect is considerable.

In the invention according to claim 10, the extension region erasing unit is formed by using a field programmable gate array. The field programmable gate array makes data blocks which do not include extension ranges pass therethrough, and erases only pixel data of the extension ranges of data blocks including the extension ranges, during transmission of the data blocks. In contrast, in the related art, a software process is performed in which all pixel data items of data blocks are transmitted to a memory device, and then pixel data of an extension range are erased. Accordingly, additional time for a software process or the like for erasing pixel data of extension ranges is not necessary, and thus required transmission time can be reduced.

### Brief Description of Drawings

Fig. 1 is a hardware configuration diagram of an image sensor used in an image transmission apparatus of an embodiment.
Fig. 2 is a block diagram illustrating an entire functional configuration of the image transmission apparatus of the embodiment.
Fig. 3A is a diagram illustrating a method of setting an interest region and a method of obtaining an extension interest region.
Fig. 3B is a diagram illustrating an output order of pixel data of an extension interest region.
Fig. 4 is a flowchart illustrating an image transmission method of the embodiment.
Fig. 5A is a diagram illustrating setting of a plurality of interest regions and illustrates a case where a plurality of extension interest regions do not overlap each other.
Fig. 5B is a diagram illustrating setting of a plurality of interest regions and illustrates a case where a plurality of extension interest regions overlap each other.
Fig. 5C is a diagram illustrating setting of a plurality of interest regions and illustrates a case where the regions of Fig. 5B are converted into non-overlapping regions which do not overlap each other.
Fig. 6 is a flowchart illustrating detailed sub-steps of a region optimization step.
Fig. 7 is a diagram exemplifying four extension interest regions prior to starting the region optimization step.
Fig. 8 is a diagram exemplifying a necessary small region obtained after a region subdivision sub-step and a region sorting sub-step are performed.
Fig. 9 is a diagram exemplifying a necessary small region obtained after an X axis direction connection sub-step is performed.
Fig. 10 is a diagram exemplifying a non-overlapping region obtained after a region fixation sub-step is performed.

### Description of Embodiments

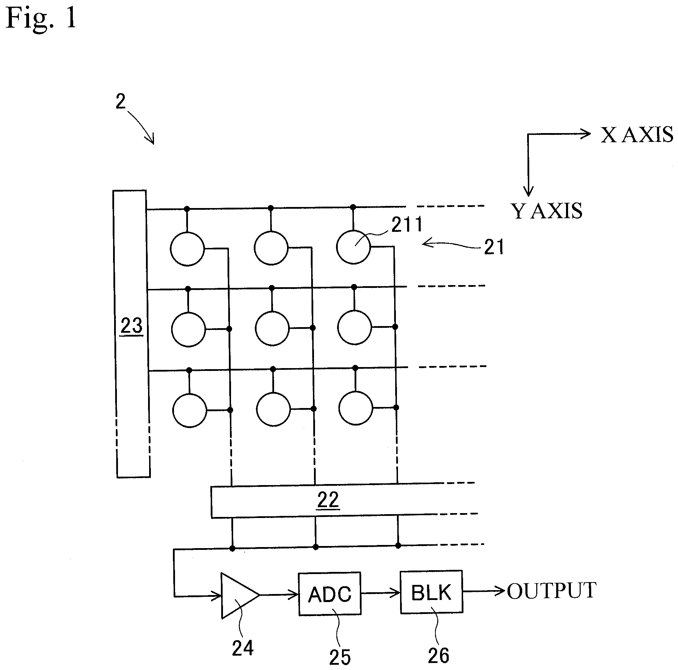

An image transmission apparatus 1 and an image transmission method of an embodiment of the invention will be described with reference to Figs. 1 to 10. Fig. 1 is a hardware configuration diagram of an image sensor 2 used in the image transmission apparatus 1 of the embodiment. The image sensor 2 includes a pixel array 21, an X axis scanning circuit 22, a Y axis scanning circuit 23, a preprocessing portion 24, an AD converter 25, a block output portion 26, and the like.

The pixel array 21 has a two-dimensional arrangement in which Nx imaging elements 211 are arranged linearly in an X axis direction on an X-Y orthogonal coordinate axes and Ny imaging element rows are arranged in a Y axis direction. Fig. 1 exemplifies the imaging elements 211 up to three elements in the X axis direction and up to three rows in the Y axis direction, and, in practice, there are a total of (Nx x Ny) imaging elements 211. For example, a CMOS element for detecting gradation is used as the imaging element 211, so as to obtain pixel data in an analog amount. In addition, the imaging element 211 may use other types of elements such as a CCD element.

The X axis scanning circuit 22 selectively controls a coordinate value (X axis coordinate value) in the X axis direction in the pixel array 21, so as to change sending of pixel data from the imaging element 211. The Y axis scanning circuit 23 selectively controls a coordinate value (Y axis coordinate value) in the Y axis direction in the pixel array 21 so as to change rows of the imaging elements 211. Accordingly, pixel data is sent from only a specified imaging element 211 to the preprocessing portion 24. The preprocessing portion 24 amplifies the pixel data which is sent to the AD converter 25. In addition, the preprocessing portion 24 performs a gain adjustment and an offset adjustment.

The AD converter 25 converts the analog pixel data into, for example, a 10-bit digital signal which is sent to the block output portion 26. The AD converter 25 is not limited thereto, and may have a resolution different from the 10 bits. The block output portion 26 collects a fixed number K of digital signals into a data block, and outputs the digital signals for each data block. Therefore, the block output portion 26 does not designate a specified imaging element 211 or output only pixel data thereof, but performs output in the data block unit into which a fixed number K of imaging elements 221 are collected.

A control portion (not illustrated) is provided in the image sensor 2 in order to control operations of the X axis scanning circuit 22, the Y axis scanning circuit 23, the AD converter 25, and the block output portion 26 of the image sensor 2. The control portion performs control so that pixel data is sequentially output in the data block unit on the basis of a command from an external device.

For example, a description will be made of a case where an entire imaging region, that is, all the imaging elements 211 become output targets on the basis of the command from an external device. First, the control portion fixes a Y axis coordinate value of the Y axis scanning circuit 23 to a first row which is the minimal value, and sequentially increases X axis coordinate values from the first column to the K-th column so as to sequentially send pixel data items of initial K imaging elements 221 of the first row of the Y axis coordinate value to the preprocessing portion 24. Accordingly, the preprocessing portion 24 and the AD converter 25 are sequentially operated, so that K digital signals are sent to the block output portion 26. Next, the block output portion 26 is operated, and collects the digital signals into an initial data block which is output as image data. Next, the control portion sequentially increases X axis coordinate values from the (K+1)-th column to the 2K-th column so as to sequentially send pixel data items of K imaging elements 221 of a second block to the preprocessing portion 24. Accordingly, the preprocessing portion 24 and the AD converter 25 are operated, so that K digital signals are sent to the block output portion 26. Next, the block output portion 26 is operated, and collects the digital signals into a second data block which is output as image data.

When this operation is repeatedly performed, and output of all Nx pixel data items of the first row of the Y axis coordinate value is completed, then, the control portion increases a Y axis coordinate value by one imaging element so as to fix the Y axis coordinate value to a second row. In addition, the control portion returns the X axis coordinate value from the first column to the K-th column so as to perform output from the block output portion 26. Next, the control portion changes X axis coordinate values from the (K+1)-th column to the 2K-th column so as to perform output from the block output portion 26, and then sequentially increases X axis coordinate values so as to perform output. Further, the image sensor 2 repeatedly performs the same operations on third and subsequent rows of Y axis coordinate values as those in the first and second rows, so as to perform output up to the Ny row which is the maximum value of Y axis coordinate values.

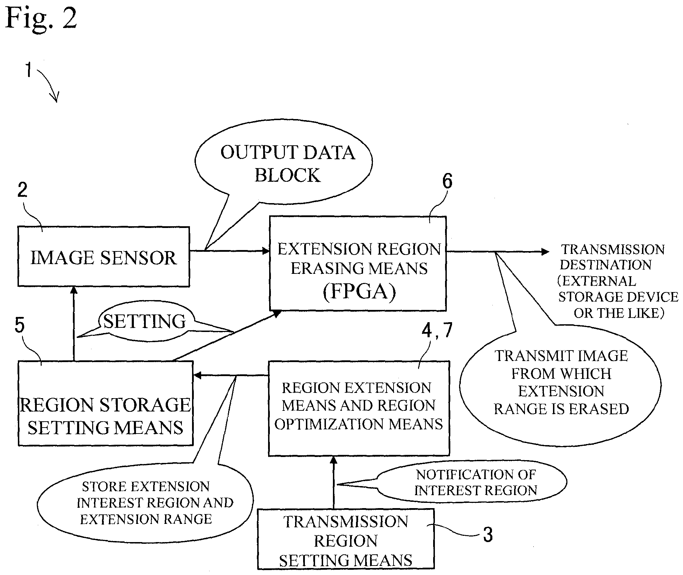

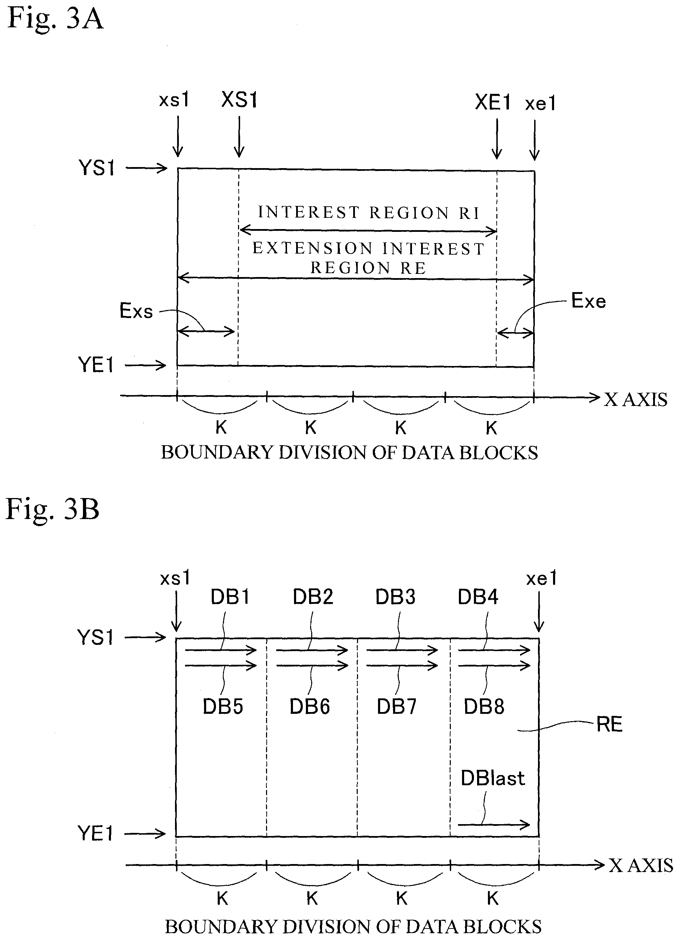

In the image transmission apparatus 1 and the image transmission method of the embodiment, in a case where image data of an entire imaging region of the image sensor 2 is not necessary, some image data is sent by setting an interest region RI. Fig. 2 is a block diagram illustrating an entire functional configuration of the image transmission apparatus 1 of the embodiment. As illustrated in Fig. 2, the image transmission apparatus 1 includes the image sensor 2, a transmission region setting unit 3, a region extension unit 4, a region storage setting unit 5, an extension region erasing unit (FPGA) 6, a region optimization unit 7, and the like, and transmits an image of an interest region RI to a transmission destination such as an external storage device. Fig. 3A is a diagram illustrating a method of setting an interest region RI and a method of obtaining an extension interest region RE, and Fig. 3B is a diagram illustrating an output order of pixel data of the extension interest region RE.

The transmission region setting unit 3 is a unit configured to set an interest region RI which is a transmission target in an imaging region by using a unit lower than a fixed number K in relation to a plurality of pixel data items which are obtained from the imaging elements 211 which capture images of the imaging region. The interest region RI may be set in the unit of a single imaging element 211. Specifically, the transmission region setting unit 3 sets any start point boundary value XS1 and end point boundary value XE1 (1≤XS1≤XE1≤Nx) represented by coordinate values in the X axis direction, and any start point boundary value YS1 and end point boundary value YE1 (1≤YS1≤YE1≤Ny) represented by coordinate values in the Y axis direction. Therefore, the interest region RI is parallel to the X axis and the Y axis, and is a rectangle including boundaries. For example, a higher-order device which is separate from the image sensor 2 functions as the transmission region setting unit 3. The transmission region setting unit 3 notifies the region extension unit 4 of the set interest region RI.

The region extension unit 4 extends the rectangular interest region RI in the X axis direction, so as to obtain a rectangular extension interest region RE. As illustrated in Fig. 3A, when the start point boundary value XS1 and the end point boundary value XE1 in the X axis direction of the interest region RI do not match the boundaries of the data block, the region extension unit 4 extends the interest region RI so as to set an extension interest region RE which matches the boundaries of the data block, and obtains a start point boundary value xs1 and an end point boundary value xe1 thereof. Accordingly, it is possible to remove an output from the image sensor 2 in the unit which is lower than the data block unit.

Here, the start point boundary value xs1=K x ks+1=XS1-Exs
the end point boundary value xe1=K x ke=XE1+Exe
(where ks and ke are integer numbers, Exs<K, and Exe<K)
In other words, the start point boundary value xs1 is a value obtained by adding 1 to a multiple of the fixed value K, and is a value which is extended further toward a smaller side by the start point side extension range Exs than the start point boundary value XS1 of the interest region. In addition, the end point boundary value xe1 is a value of a multiple of the fixed value K, and is a value which is extended further toward a greater side by the end point side extension range Exe than the end point boundary value XE1 of the interest region. The region extension unit 4 may be realized by, for example, software of the control portion (not illustrated) which is integrally formed with the image sensor 2. Further, since outputting is performed for each row in the Y axis direction, the interest region RI is not required to be extended, and the initially set start point boundary value YS1 and end point boundary value YE1 are used to set the extension interest region RE.

The region storage setting unit 5 stores the start point boundary value xs1 and the end point boundary value xe1 in the X axis direction of the extension interest region RE, the start point side extension range Exs and the end point side extension range Exe, and the start point boundary value YS1 and the end point boundary value YE1 in the Y axis direction, described above. In addition, the region storage setting unit 5 sets the values xs1, xe1, Exs, Exe, YS1 and YE1 in the image sensor 2 and the extension region erasing unit 6. The region storage setting unit 5 may be realized by, for example, software and a memory of the control portion (not illustrated) integrally formed with the image sensor 2.

The image sensor 2 performs imaging, and then sequentially outputs data blocks included in the extension interest region RE on the basis of the set start point boundary value xs1, end point boundary value xe1, start point boundary value YS1, and end point boundary value YE1 from the region storage setting unit 5. Specifically, as illustrated in Fig. 3B, first, the image sensor 2 fixes a Y axis coordinate value to the start point boundary value YS1 which is the minimum value of the extension interest region RE, and changes X axis coordinate values from the start point boundary value xs1 which is the minimum value of the extension interest region to the end point boundary value xe1 which is the maximum value, so as to sequentially output four data blocks (DB1 to DB4 of the figure) of the first row. Next, the image sensor 2 fixes a Y axis coordinate value to a coordinate value (YS1+1) which is increased by a single imaging element, and sequentially outputs four data blocks (DB5 to DB8) of the second row. In addition, the image sensor 2 repeatedly outputs data blocks of each row so as to output the last data block (DBlast of the figure) of the end point boundary value YE1 which is the maximum value of a Y axis coordinate value. Therefore, an output unit of the invention is realized through cooperation of the image sensor 2 and the region storage setting unit 5.

The extension region erasing unit 6 erases pixel data of the start point side extension range Exs and the end point side extension range Exe from the output data blocks, so as to obtain an image of the interest region RI. The extension region erasing unit 6 is formed by using a field programmable gate array (FPGA). The field programmable gate array is a kind of programmable logic device. The extension region erasing unit 6 is operated on the basis of setting from the region storage setting unit 5. The extension region erasing unit 6 makes data blocks which do not include the start point side extension range Exs and the end point side extension range Exe pass therethrough as they are, and erases only pixel data of the extension ranges Exs and Exe of data blocks including the start point side extension range Exs and the end point side extension range Exe, during transmission of the data blocks. Accordingly, the image data transmitted to a transmission destination is not limited to the interest region RI, and thus a proper image for the set interest region RI can be obtained.

The region optimization unit 7 is integrally formed with the region extension unit 4. The region optimization unit 7 is subsequently operated to the region extension unit 4 in a case where a plurality of interest regions RI are set by the transmission region setting unit 3, and a plurality of extension interest regions RE which are obtained by the region extension unit 4 partially overlap each other. The region optimization unit 7 converts the plurality of extension interest regions RE into non-overlapping regions which do not overlap each other. In this case, the region storage setting unit 5 stores and sets the non-overlapping region instead of the extension interest region RE. A function of the region optimization unit 7 will be described in detail along with description of the following image transmission operation.

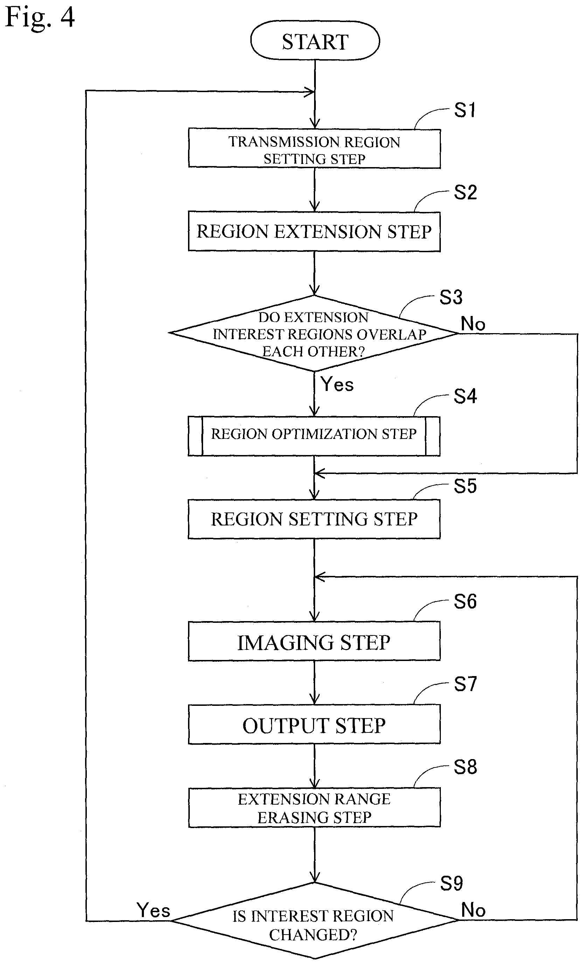

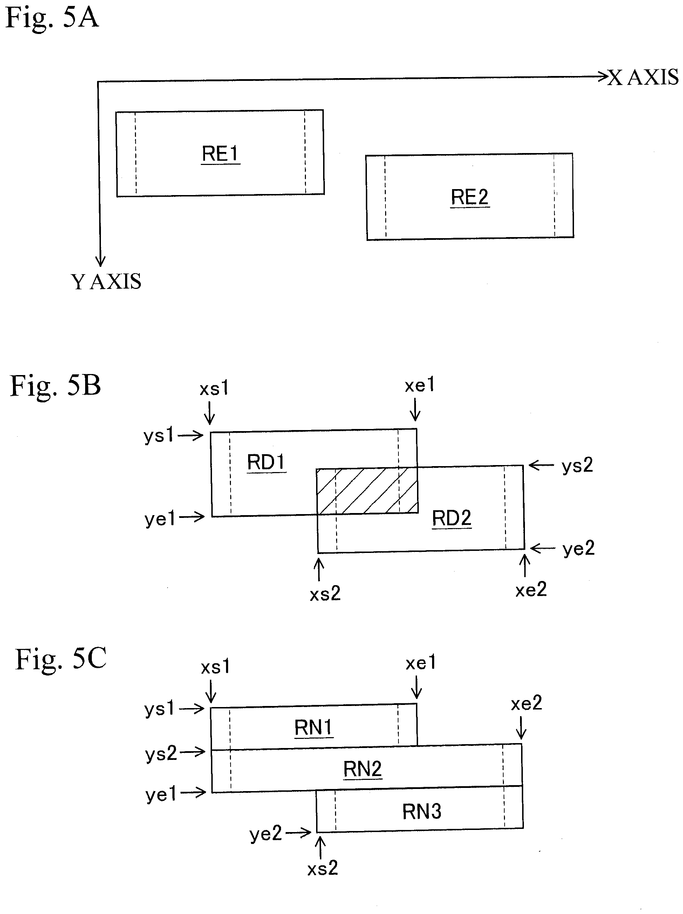

Next, an image transmission operation performed by the image transmission apparatus 1 of the embodiment, that is, an image transmission method of the embodiment will be described. Fig. 4 is a flowchart illustrating the image transmission method of the embodiment. In transmission region setting step S1 of Fig. 4, the transmission region setting unit 3 sets an interest region RI which is a transmission target in an imaging region by using the imaging elements 211 in the unit lower than the fixed number K. Specifically, the start point boundary value XS1 and the end point boundary value XE1 in the X axis direction of the interest region RI and the start point boundary value YS1 and the end point boundary value YE1 in the Y axis direction thereof are set. Fig. 5A is a diagram illustrating setting of a plurality of interest regions RI, and illustrates a case where a plurality of extension interest regions RE1 and RE2 do not overlap each other. Fig. 5B is a diagram illustrating setting of a plurality of interest regions RI, and illustrates a case where a plurality of extension interest regions RD1 and RD2 overlap each other. Fig. 5C is a diagram illustrating setting of a plurality of interest regions RI, and illustrates a case where the regions of Fig. 5B are converted into non-overlapping regions RN1 to RN3 which do not overlap each other. In a case where a plurality of interest regions RI are set, four boundary values XS1, XE1, YS1 and YE1 are set for each of the interest regions RI.

In subsequent region extension step S2, the region extension unit 4 extends the interest region RI so as to obtain an extension interest region RE in which a data block is represented as a unit and also to obtain extension ranges from the interest region RI to the extension interest region RE. Specifically, the start point boundary value xs1 and the end point boundary value xe1 of the extension interest region RE, and the start point side extension range Exs and the end point side extension range Exe are obtained, and are stored in the region storage setting unit 5 along with the start point boundary value YS1 and the end point boundary value YE1 in the Y axis direction.

Next, in step S3, it is determined whether or not the extension interest regions RE overlap each other. In a case where the number of interest region RI exemplified in Fig. 3A is one, and in a case where the plurality of extension interest regions RE1 and RE2 exemplified in Fig. 5A do not overlap each other, subsequent region optimization step S4 is not necessary, and the flow proceeds to region setting step S5.

In subsequent region setting step S5, the region storage setting unit 5 sets the start point boundary value xs1 and the end point boundary value xe1 in the X axis direction, the start point side extension range Exs and the end point side extension range Exe, and the start point boundary value YS1 and the end point boundary value YE1 in the Y axis direction of the single extension interest region RE or each of the plurality of extension interest regions RE1 and RE2 which do not overlap each other, in the image sensor 2 and the extension region erasing unit 6. Accordingly, preparations for imaging and transmission of image data are completed.

In subsequent imaging step S6, the image sensor 2 performs imaging, and obtains pixel data by using the respective imaging elements 221 which capture an image of the imaging region. In addition, the block output portion 26 collects pixel data items included in the extension interest regions RE, RE1 and RE2 into data blocks. In subsequent output step S7, the image sensor 2 sequentially outputs the data blocks from the block output portion 26. The operation of collecting pixel data into a data block in imaging step S6 and the operation of outputting the data block in output step S7 are repeatedly performed for the number of times corresponding to the number of data blocks of the extension interest regions RE, RE1 and RE2.

In subsequent extension range erasing step S8, the extension region erasing unit 6 erases pixel data of the start point side extension range Exs and the end point side extension range Exe from the data blocks of which transmission is in progress. Accordingly, an image of the interest region RI can be obtained in a transmission destination. Next, it is determined whether or not the interest region RI is changed in step S9, and if the interest region is changed, the flow returns to transmission region setting step S1. In addition, if the interest region is not changed, the flow may return to imaging step S6, and the next imaging may be successively performed.

Next, an image transmission operation performed by the image transmission apparatus 1 of the embodiment when two extension interest regions RD1 and RD2 overlap each other, that is, an image transmission method of the embodiment will be described. Even when the two extension interest regions RD1 and RD2 overlap each other, an operation is performed according to the flowchart of Fig. 4, but there is a difference in that region optimization step S4 is performed. As exemplified in Fig. 5B, it is assumed that the two interest regions set in transmission region setting step S1 are extended in region extension step S2, and boundary values xs1, xe1, ys1 and ye1 of the first extension interest region RD1 and boundary values xs2, xe2, ys2 and ye2 of the second extension interest region RD2 are obtained. At this time, a magnitude relationship of the boundary values in the X axis direction is xs1<xs2<xe1<xe2, and a magnitude relationship of the boundary values in the Y axis direction is ys1<ys2<ye1<ye2. In other words, the two extension interest regions overlap each other (indicated with hatching in the figure) in a range from xs2 to xe1 in the X axis direction and a range from ys2 to ye1 in the Y axis direction.

Here, it is assumed that the image sensor 2 separately outputs pixel data of the first and second extension interest regions RD1 and RD2 in this order. Then, pixel data of the overlapping part has already vanished in the second extension interest region RD2 which is output later, and thus an accurate image cannot be obtained in a transmission destination. Therefore, in region optimization step S4, the region optimization unit 7 converts the first and second extension interest regions RD1 and RD2 into three non-overlapping regions RN1, RN2 and RN3 which do not overlap each other, illustrated in Fig. 5C. In this example, the first non-overlapping region RN1 has boundary values xs1, xe1, ys1 and ys2, the second non-overlapping region RN2 has boundary values xs1, xe2, ys2 and ye1, and the third non-overlapping region RN3 has boundary values xs2, xe2, ye1 and ye2.

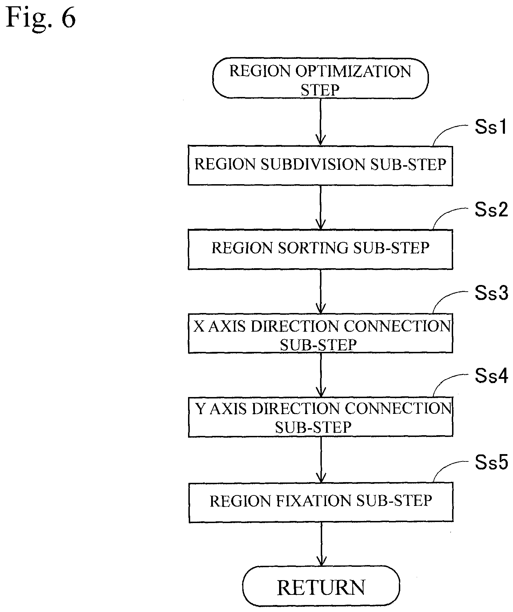

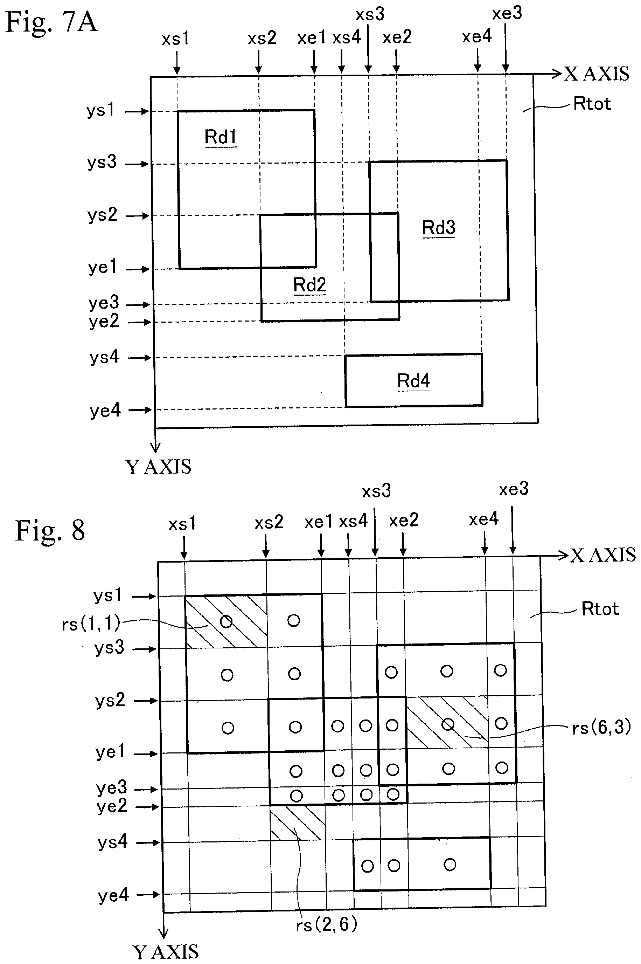

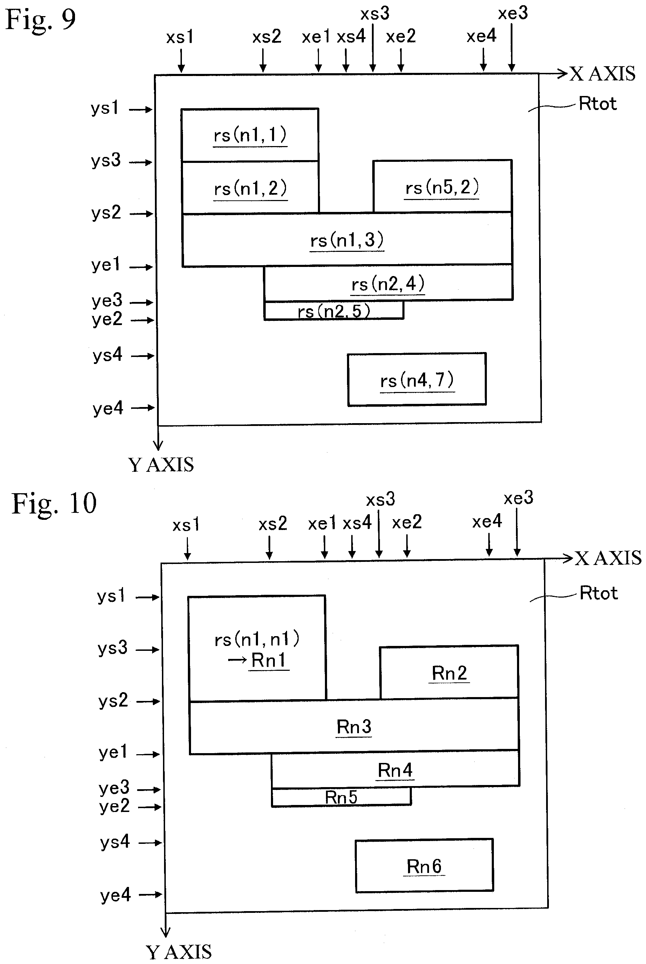

In the above case, the non-overlapping regions RN1 to RN3 are relatively easily obtained, but, hereinafter, a description will be made of a general method of region optimization step S4 (region optimization unit 7) which is suitable even for a case where the number of interest regions RI serving as bases increases. Fig. 6 is a flowchart illustrating detailed sub-steps of region optimization step S4. In addition, Fig. 7 exemplifies four extension interest regions Rd1 to Rd4 prior to starting region optimization step S4, and Fig. 8 exemplifies necessary small regions obtained after region subdivision sub-step Ss1 and region sorting sub-step Ss2 are performed. In addition, Fig. 9 exemplifies necessary small regions obtained after X axis direction connection sub-step Ss3 is performed, and Fig. 10 exemplifies non-overlapping regions Rn1 to Rn6 obtained after region fixation sub-step Ss5 is performed.

First, it is assumed that four interest regions RI are set and are extended to four extension interest regions Rd1 to Rd4, and boundary values thereof are the following values as exemplified in Fig. 7.
Boundary values xs1, xe1, ys1 and ye1 of the first extension interest region Rd1
Boundary values xs2, xe2, ys2 and ye2 of the second extension interest region Rd2
Boundary values xs3, xe3, ys3 and ye3 of the third extension interest region Rd3
Boundary values xs4, xe4, ys4 and ye4 of the fourth extension interest region Rd4
Here, xs1<xs2<xe1<xs4<xs3<xe2<xe4<xe3
ys1<ys3<ys2<ye1<ye3<ye2<ys4<ye4

Then, in region subdivision sub-step Ss1 of Fig. 6, an imaging region Rtot is subdivided into a plurality of small regions rs with a lattice shape by using all the boundary values in the X axis direction and Y axis direction of the first to fourth extension interest regions Rd1 to Rd4. There are eight boundary values as the boundary values in the X axis direction and Y axis direction. The boundary values are sorted in an ascending order so as to be arranged in a smaller order, thereby being easily subdivided into small regions rs. A subdivision result is as illustrated in Fig. 8, and the number of small regions rs is 49 (=7 x 7), and each of the small region is denoted by small region rs(x,y) (where x=1 to 7, and y=1 to 7). In Fig. 8, three regions including a small region rs(1,1), a small region rs(2,6), and a small region rs(6,3) are hatched for convenience and are exemplified.

In subsequent region sorting sub-step Ss2, each small region rs(x,y) is sorted into necessary small regions inside the first to fourth extension interest regions Rd1 to Rd4 and unnecessary small regions outside the first to fourth extension interest regions Rd1 to Rd4. In Fig. 8, the small region rs(1,1) and the small region rs(2,1) are sorted as necessary small regions inside the first extension interest region Rd1, and five regions which are continuously located from the small region rs(3,1) to the small region rs(7,1) in the X axis direction are sorted as unnecessary small regions. In addition, for example, the small region rs(2,3) is a part where the first and second extension interest regions Rd1 and Rd2 overlap each other, and is sorted as a necessary small region. In Fig. 8, as a sorting result, twenty-seven necessary small regions are given O marks and are illustrated.

In subsequent X axis direction connection sub-step Ss3, a plurality of necessary small regions which are continuously located in the X axis direction are connected to each other so as to be replaced with a new necessary small region. Specifically, the necessary small region rs(1,1) and the necessary small region rs(2,1) which are continuously located in the X axis direction are connected to each other so as to be set as a necessary small region rs(n1,1). Similarly, the necessary small region rs(1,2) and the necessary small region rs(2,2) which are continuously located in the X axis direction are connected to each other so as to be set as a necessary small region rs(n1,2). In addition, three regions including the necessary small region rs(5,2), the necessary small region rs(6,2), and the necessary small region rs(7,2) are connected to each other so as to be set as a necessary small region rs(n5,2). Further, seven regions which are continuously located from the necessary small region rs(1,3) to the necessary small region rs(7,3) in the X axis direction are connected to each other so as to be set as a necessary small region rs(n1,3). In this way, the plurality of necessary small regions are replaced with a new necessary small region rs(n2,4), a new necessary small region rs(n2,5), and a new necessary small region rs(n4,7). Accordingly, the twenty-seven necessary small regions rs with the O marks in Fig. 8 are replaced with the new seven necessary small regions rs illustrated in Fig. 9.

In subsequent Y axis direction connection sub-step Ss4, a plurality of necessary small regions which are continuously located in the Y axis direction and have the same X axis coordinate values indicating boundaries are connected to each other so as to be replaced with new necessary small regions. In the example of Fig. 9, the necessary small region rs(n1,1) and the necessary small region rs(n1,2) have the same start point boundary value xs1 and end point boundary value xe1, and thus the two small regions are combined with each other so as to be replaced with a new necessary small region rs(n1,n1). Among the other regions, there are no necessary small regions which have the same start point boundary value and end point boundary value in the X axis direction. Accordingly, the number of necessary small regions rs is six.

In subsequent region fixation sub-step Ss5, the six necessary small regions rs obtained after X axis direction connection sub-step Ss3 and Y axis direction connection sub-step Ss4 are finished are changed to rectangular non-overlapping regions Rn1 to Rn6. For example, as illustrated in Fig. 10, the necessary small region rs(n1,n1) is changed to the first non-overlapping region Rn1, and, similarly, the other necessary small regions rs are changed to the second to sixth non-overlapping regions Rn2 to Rn6. Subsequently, the flow proceeds to region setting step S5 of the flowchart of Fig. 4, and data blocks of the non-overlapping regions Rn1 to Rn6 are output in output step S7.

In addition, even if a data block of each of the twenty-seven necessary small regions rs is output without performing steps after X axis direction connection sub-step Ss3, images of four interest regions may be obtained in a transmission destination. However, at this time, twenty-seven patterns are necessary in transmission control setting, and thus transmission control is complicated and required transmission time increases. In contrast, if processes up to region fixation sub-step Ss5 are performed prior to starting imaging step S5, since transmission control setting is completed by six patterns, transmission control is simplified, and required transmission time is reduced.

According to the image transmission apparatus 1 and the image transmission method of the embodiment, an interest region RI can be set in the unit of a single imaging element 211. At this time, extension interest regions RE, RE1 and RE2 are obtained, data blocks included in the extension interest regions RE, RE1 and RE2 are output from the image sensor, and pixel data items of the extension ranges Exs and Exe are erased from the output data blocks so that an image of the interest region RI can be obtained. Therefore, any interest region RI can be set without being aware of the number K of pixel data of a data block. In addition, an output data block is regarded as the required minimum, and thus required transmission time can be further reduced than in a case where pixel data of the entire imaging region Rtot is transmitted.

In addition, the image transmission apparatus 1 of the embodiment converts some of the plurality of extension interest regions RD1, RD2, and Rd1 to Rd4 which overlap each other into the non-overlapping regions RN1 to RN3 and Rn1 to Rn6 which do not overlap each other, and outputs data blocks included in the non-overlapping regions RN1 to RN3 and Rn1 to Rn6. Therefore, proper data blocks for the plurality of extension interest regions RD1, RD2, and Rd1 to Rd4 are output, and thus it is possible to obtain correct images of a plurality of interest regions and also to reduce required transmission time.

In addition, the image sensor 2 of the embodiment has a plurality of imaging elements 221 arranged in a two-dimensional manner on the X-Y orthogonal coordinate axes, and thus a practical effect is considerable.

Further, region optimization step S4 includes five sub-steps Ss1 to Ss5, and the plurality of rectangular extension interest regions Rd1 to Rd4 which overlap each other are converted into the rectangular non-overlapping regions Rn1 to Rn6 which do not overlap each other and are not continuously located in the X axis direction. Since the number of non-overlapping regions Rn1 to Rn6 obtained in this way is minimized and optimized, the image transmission apparatus 1 can output a data block without unnecessarily subdividing a region, and thus transmission control can be simplified and required transmission time can be reduced.

Furthermore, since the extension region erasing unit 6 is formed by using a field programmable gate array, additional time for a software process or the like for erasing pixel data of the extension ranges Exs and Exe is not necessary, and thus required transmission time can be reduced.

Moreover, the image sensor 2 described in the embodiment is only an example, and other types of image sensors may be used. In addition, each of the transmission region setting unit 3, the region extension unit 4, the region storage setting unit 5, and the region optimization unit 7 may be formed by using software as appropriate, and various applications of setting methods or calculation process methods may be possible. Further, even the extension region erasing unit 6 is not limited to a field programmable gate array. Furthermore, the invention may have various applications or modifications.

### Industrial Applicability

The image transmission method and the image transmission apparatus of the invention can be suitably used in a board production apparatus or a board production line which performs predetermined production steps on a board on the basis of image data obtained through imaging of a camera (image sensor). In addition, the image transmission method and the image transmission apparatus of the invention can be widely used in a step monitoring apparatus which monitors production circumstances with various productions other than a board as targets by referring to imaging data of a part of an imaging region of an image sensor, an image inspection apparatus which determines whether or not a product is defective on the basis of some imaging data of an image sensor, or the like.

### Reference Signs List

1: Image transmission apparatus
2: Image sensor
   21: Pixel array
   22: X axis scanning circuit
   23: Y axis scanning circuit
   24: Preprocessing portion
   25: AD converter
   26: Block output portion
3: Transmission region setting unit
4: Region extension unit
5: Region storage setting unit
6: Extension region erasing unit (FPGA=field programmable gate array)
7: Region optimization unit
K: Fixed number
RI: Interest region
RE, RE1, RE2: Extension interest region (which do not overlap each other)
RD1, RD2, Rd1 to Rd4: Overlapping extension interest region
RN1 to RN3, Rn1 to Rn6: Non-overlapping region
rs, rs(x,y): Small region, necessary small region

## Claims

1. A method for outputting image data from an image sensor (2), the image sensor (2) being configured to capture an image by using a plurality of imaging elements (211) arranged in a two-dimensional manner on X-Y orthogonal coordinate axes, the image sensor (2) is divided in an X axis direction into block element groups each having the same number (K) of imaging elements (211), the image sensor being configured to collect a fixed number (K) of pixel data obtained by the respective imaging elements (211) into a data block, and to output the pixel data of the imaging elements (211) in data blocks each including the pixel data of one block element group of imaging elements (211), the method comprises the steps of:
an imaging step (S6) of performing imaging with the image sensor (2), and obtaining pixel data from the respective imaging elements (211)
a interest region setting step (S1) of setting an interest region (RI) being an image region smaller than the entire image set by a start point boundary value (XS1) and end point boundary value (XE1) in the X axis direction;
a region extension step (S2) of extending the interest region (RI) when the start point boundary value (XS1) and the end point boundary value (XE1) in the X axis direction of the interest region (RI) do not match the boundaries of the block element groups, the region extension step (S2) extends the interest region (RI) by extension ranges (Exs, Exe) in the X axis direction so as to set an extended interest region (RE) which matches the boundaries of the block element group;
the imaging step (S6) obtains the pixel data from the respective imaging elements (211) in the extended interest region (RE);
an output step (S7) of outputting only the data blocks included in the extended interest region (RE) from the image sensor (2); and
an extension range erasing step (S8) of erasing pixel data of the extension ranges (Exs, Exe) from the output data blocks so as to obtain an image of the interest region.

2. The method according to claim 1, further comprising: a region optimization step (S4) of converting a plurality of extended interest regions into non-overlapping regions which do not overlap each other, subsequently to the region extension step (S2), when a plurality of interest regions are set in the transmission region setting step (S1), and some of the plurality of extended interest regions obtained in the region extension step overlap each other,
wherein, in the output step (S7), data blocks included in the non-overlapping regions are output instead of the extended interest regions.

3. The method according to claim 1,
wherein, in the transmission region setting step (S1), a rectangular interest region parallel to an X axis and a Y axis is set, wherein, in the region extension step (S2), the rectangular interest region is extended to the X axis direction so that a rectangular extended interest region is obtained, and
wherein, in the output step (S7), a Y axis coordinate value of an imaging element (211) which is an output target is initially fixed to a minimum value of the extended interest region, an X axis coordinate value is changed from one of the minimum value and a maximum value of the extended interest region to the other value so that a data block of a first row is output, then a Y axis coordinate value of an imaging element (211) which is the output target is increased by one imaging element so as to be fixed, an X axis coordinate value is changed from one of the minimum value and the maximum value of the extended interest region to the other value so that a data block of a second row is output, and a data block of each row is repeatedly output until a Y axis coordinate value of an imaging element which is the output target becomes a maximum value of the extended interest region so that all data blocks included in the rectangular extended interest region are output.

4. The method according to claim 3, further comprising:
a region optimization step (S4) of converting a plurality of rectangular extended interest regions into rectangular non-overlapping regions which do not overlap each other and are not continuously located in the X axis direction, subsequently to the region extension step, when a plurality of rectangular interest regions are set in the transmission region setting step (S1), and some of the plurality of rectangular extended interest regions obtained in the region extension step overlap each other,
wherein, in the output step (S7), all data blocks included in the rectangular non-overlapping regions are output instead of the rectangular extended interest regions (RE).

5. The method according to claim 4,
wherein the region optimization step (S4) includes: a region subdivision sub-step (Ss1) of subdividing the imaging region into a plurality of small regions with a lattice shape by using all X axis coordinate values and Y axis coordinate values indicating boundaries of the plurality of rectangular extended interest regions;
a region sorting sub-step (Ss2) of sorting each of the small regions into a necessary small region inside the extended interest region and an unnecessary small region outside the extended interest region;
an X axis direction connection sub-step (Ss3) of connecting a plurality of necessary small regions which are continuously located in the X axis direction so as to replace the plurality of necessary small regions with new necessary small regions;
a Y axis direction connection sub-step (Ss4) of connecting a plurality of necessary small regions which are continuously located in the Y axis direction and have the same X axis coordinate values indicating the boundaries so as to replace the plurality of necessary small regions with new necessary small regions; and
a region fixation sub-step (Ss5) of using the necessary small regions obtained after the X axis direction connection sub-step and the Y axis direction connection sub-step are finished, as the rectangular non-overlapping regions.

6. An apparatus for outputting image data from an image sensor (2), comprising:
an image sensor (2) being configured to capture an image by using a plurality of imaging elements (211) arranged in a two-dimensional manner on X-Y orthogonal coordinate axes and to output the pixel data of the imaging elements (211), the image sensor (2) is divided in an X axis direction into block element groups each having the same number (K) of imaging elements (211), the image sensor being configured to collect a fixed number (K) of pixel data obtained by the respective imaging elements (211) into a data block, and to output the pixel data for each data block, and to output the pixel data of the imaging elements (211) in data blocks each data block including the pixel data of one block element group of imaging elements (211);
interest region setting means (3) for setting an interest region (RI) being an image region smaller than the entire image set by a start point boundary value (XS1) and end point boundary value (XE1) in the X axis direction ;
region extension means (4) for extending the interest region (RI) when the start point boundary value (XS1) and the end point boundary value (XE1) in the X axis direction of the interest region (RI) do not match the boundaries of the block element groups, the region extension means (4) extends the interest region (RI) by extension ranges (Exs, Exe) in the X axis direction so as to set an extended interest region (RE) which matches the boundaries of the block element groups;
output means (26) for outputting only the data blocks included in the extended interest region (RE) from the image sensor (2); and
extension region erasing means (6) for erasing pixel data of the extension ranges (Exs, Exe) from the output data blocks so as to obtain an image of the interest region (RI).

7. The apparatus according to claim 6, further comprising:
region optimization means (7), operated subsequently to the region extension means (14), for converting a plurality of extended interest regions into non-overlapping regions which do not overlap each other, when a plurality of interest regions are set by the transmission region setting means (3), and some of the plurality of extended interest regions obtained by the region extension means (4) overlap each other,
wherein the output means (26) outputs data blocks included in the non-overlapping regions instead of the extended interest regions.

8. The apparatus according to claim 6, further comprising
a multiplexer that changes and selects block element groups obtained by dividing the plurality of imaging elements which are linearly arranged in the X axis direction in a unit of the fixed number; and
AD converters (25), with the same number as the fixed number, that digitalize pixel data of each image element of a block element group selected by the multiplexer,
wherein the transmission region setting means (3) sets a rectangular interest region parallel to an X axis and a Y axis,
wherein the region extension means (4) extends the rectangular interest region to the X axis direction so as to obtain a rectangular extended interest region, and
wherein the output means (26) fixes a Y axis coordinate value of an imaging element which is an initial output target to a minimum value of the extended interest region, digitalizes and outputs pixel data of each image element of a block element group of a first row by using the AD converter (25), increases and fixes a Y axis coordinate value of an imaging element which is the next output target by one imaging element to a certain value, digitalizes and outputs pixel data of each image element of a block element group of a second row by using the AD converter (25), and repeatedly outputs pixel data of each image element of a block element group of each row until a Y axis coordinate value of an imaging element which is the output target becomes a maximum value of the extended interest region so that all data blocks included in the rectangular extended interest region are output.

9. The apparatus according to claim 8, further comprising:
region optimization means (7), operated subsequently to the region extension means (4), for converting a plurality of rectangular extended interest regions into rectangular non-overlapping regions which do not overlap each other and are not continuously located in the X axis direction, when a plurality of rectangular interest regions are set by the transmission region setting means, and some of the plurality of rectangular extended interest regions obtained by the region extension means overlap each other,
wherein the output means (26) outputs all data blocks included in the rectangular non-overlapping regions instead of the rectangular extended interest regions.

10. The apparatus according to any one of claims 6 to 9, wherein the extension region erasing means (6) is formed by using a field programmable gate array.

## Patentansprüche

1. Verfahren zum Ausgeben von Bilddaten von einem Bildsensor (2), wobei der Bildsensor (2) konfiguriert ist zum Aufnehmen eines Bilds unter Verwendung einer Vielzahl von Bildaufnahmesensoren (211), die zweidimensional auf orthogonalen X-Y-Koordinatenachsen angeordnet sind, wobei der Bildsensor (2) in einer X-Achsenrichtung in Blockelementgruppen unterteilt ist, die jeweils die gleiche Anzahl (K) von Bildaufnahmeelementen (211) aufweisen, wobei der Bildsensor konfiguriert ist zum Sammeln einer fixen Anzahl (K) von Pixeldaten, die durch die entsprechenden Bildaufnahmeelemente (211) erhalten werden, zu einem Datenblock und zum Ausgeben der Pixeldaten der Bildaufnahmeelemente (211) in Datenblöcken, die jeweils die Pixeldaten einer Blockelementgruppe von Bildaufnahmeelementen (211) enthalten, wobei das Verfahren die folgenden Schritte umfasst:
einen Bildaufnahmeschritt (S6) zum Durchführen einer Bildaufnahme mit dem Bildsensor (2) und zum Erhalten von Pixeldaten von den entsprechenden Bildaufnahmeelementen (211),
einen Interessanter-Bereich-Setzschritt (S1) zum Setzen eines interessanten Bereichs (RI), der ein Bildbereich ist, der kleiner als das gesamte Bild ist und durch einen Startpunkt-Grenzwert (XS1) und einen Endpunkt-Grenzwert (XE1) in der X-Achsenrichtung gesetzt wird,
einen Bereichserweiterungsschritt (S2) zum Erweitern des interessanten Bereichs (RI), wenn der Startpunkt-Grenzwert (XS1) und der Endpunkt-Grenzwert (XE1) in der X-Achsenrichtung des interessanten Bereichs (RI) nicht mit den Grenzen der Blockelementgruppen übereinstimmen, wobei der Bereichserweiterungsschritt (S2) den interessanten Bereich (RI) um Erweiterungsbereiche (Exs, Exe) in der X-Achsenrichtung erweitert, um einen erweiterten interessanten Bereich (RE) zu setzen, der den Grenzen der Blockelementgruppe entspricht,
wobei der Bildaufnahmeschritt (S6) die Pixeldaten von den entsprechenden Bildaufnahmeelementen (211) in dem erweiterten interessanten Bereich (RE) erhält,
einen Ausgabeschritt (S7) zum Ausgeben nur der Datenblöcke, die in dem erweiterten interessanten Bereich (RE) enthalten sind, von dem Bildsensor (2), und
einen Erweiterungsbereich-Löschschritt (S8) zum Löschen von Pixeldaten der Erweiterungsbereiche (Exs, Exe) aus den ausgegebenen Datenblöcken, um ein Bild des interessanten Bereichs zu erhalten.

2. Verfahren nach Anspruch 1, das weiterhin umfasst:
einen Bereichsoptimierungsschritt (S4) zum Wandeln einer Vielzahl von erweiterten interessanten Bereichen zu nicht-überlappenden Bereichen, die nicht miteinander überlappen, auf den Bereichserweiterungsschritt (S2) folgend, wenn eine Vielzahl von interessanten Bereichen in dem Interessanter-Bereich-Setzschritt (S1) gesetzt werden und einige aus der in dem Bereichserweiterungsschritt erhaltenen Vielzahl von erweiterten interessanten Bereichen einander überlappen,
wobei in dem Ausgabeschritt (S7) Datenblöcke, die in den nicht-überlappenden Bereichen enthalten sind, anstatt der erweiterten interessanten Bereiche ausgegeben werden.

3. Verfahren nach Anspruch 1,
wobei in dem Interessanter-Bereich-Setzschritt (S1) ein rechtwinkliger interessanter Bereich parallel zu einer X-Achse und einer Y-Achse gesetzt wird, wobei in dem Bereichserweiterungsschritt (S2) der rechtwinklige interessante Bereich zu der X-Achsenrichtung erweitert wird, sodass ein rechtwinkliger erweiterter interessanter Bereich erhalten wird, und
wobei in dem Ausgabeschritt (S7) ein Y-Achsen-Koordinatenwert eines Bildaufnahmeelements (211), das ein Ausgabeziel ist, zu Beginn bei einem minimalen Wert des erweiterten interessanten Bereichs fixiert wird, ein X-Achsen-Koordinatenwert von dem minimalen Wert oder dem maximalen Wert des erweiterten interessanten Bereichs zu dem jeweils anderen Wert geändert wird, sodass ein Datenblock einer ersten Reihe ausgegeben wird, dann ein X-Achsen-Koordinatenwert eines Bildaufnahmeelements (211), das das Ausgabeziel ist, um ein Bildaufnahmeelement erhöht wird, um fixiert zu werden, ein X-Achsen-Koordinatenwert von dem minimalen Wert oder dem maximalen Wert des erweiterten interessanten Bereichs zu dem jeweils anderen Wert geändert wird, sodass ein Datenblock einer zweiten Reihe ausgegeben wird, und ein Datenblock jeder Reihe wiederholt ausgegeben wird, bis ein Y-Achsen-Koordinatenwert eines Bildaufnahmeelements, das das Ausgabeziel ist, ein maximaler Wert des erweiterten interessanten Bereichs wird, sodass alle Datenblöcke in dem rechtwinkligen erweiterten interessanten Bereich ausgegeben werden.

4. Verfahren nach Anspruch 3, das weiterhin umfasst:
einen Bereichsoptimierungsschritt (S4) zum Wandeln einer Vielzahl von rechtwinkligen erweiterten interessanten Bereichen zu rechtwinkligen nicht-überlappenden Bereichen, die nicht miteinander überlappen und nicht kontinuierlich in der X-Achsenrichtung angeordnet sind, auf den Bereichserweiterungsschritt folgend, wenn eine Vielzahl von rechtwinkligen interessanten Bereichen in dem Interessanter-Bereich-Setzschritt (S1) gesetzt werden und einige aus der in dem Bereichserweiterungsschritt erhaltenen Vielzahl von rechtwinkligen erweiterten interessanten Bereichen miteinander überlappen,
wobei in dem Ausgabeschritt (S7)alle Datenblöcke, die in den rechtwinkligen nicht-überlappenden Bereichen enthalten sind, anstelle der rechtwinkligen erweiterten interessanten Bereiche (RE) ausgegeben werden.

5. Verfahren nach Anspruch 4, wobei der Bereichsoptimierungsschritt (S4) umfasst:
einen Bereichsunterteilungs-Teilschritt (Ss1) zum Unterteilen des Bildaufnahmebereichs in eine Vielzahl von kleinen Bereichen mit einer Gitterform unter Verwendung aller X-Achsen-Koordinatenwerte und Y-Achsen-Koordinatenwerte, die Grenzen der Vielzahl von rechtwinkligen erweiterten interessanten Bereichen angeben,
einen Bereichssortierungs-Teilschritt (Ss2) zum Sortieren jedes der kleinen Bereiche in einen erforderlichen kleinen Bereich innerhalb des erweiterten interessanten Bereichs und einen nicht-erforderlichen kleinen Bereich außerhalb des erweiterten interessanten Bereichs,
einen X-Achsenrichtung-Verbindungs-Teilschritt (Ss3) zum Verbinden einer Vielzahl von erforderlichen kleinen Bereichen, die aufeinander folgend in der X-Achsenrichtung angeordnet sind, um die Vielzahl von erforderlichen kleinen Bereichen durch neue erforderliche kleine Bereiche zu ersetzen,
einen Y-Achsenrichtung-Verbindungs-Teilschritt (Ss4) zum Verbinden einer Vielzahl von erforderlichen kleinen Bereichen, die aufeinander folgend in der Y-Achsenrichtung angeordnet sind und die gleichen X-Achsen-Koordinatenwerte für das Angeben der Grenzen aufweisen, um die Vielzahl von erforderlichen kleinen Bereichen durch neue erforderliche kleine Bereiche zu ersetzen, und
einen Bereichsfixierungs-Teilschritt (Ss5) zum Verwenden der erforderlichen kleinen Bereiche, die nach Abschluss des X-Achsenrichtung-Verbindungs-Teilschritts und des Y-Achsen-Verbindungs-Teilschritts erhalten werden, als der rechteckigen nicht-überlappenden Bereiche.

6. Vorrichtung zum Ausgeben von Bilddaten von einem Bildsensor (2), umfassend:
einen Bildsensor (2), der konfiguriert ist zum Aufnehmen eines Bildes unter Verwendung einer Vielzahl von Bildaufnahmesensoren (211), die zweidimensional auf orthogonalen X-Y-Koordinatenachsen angeordnet sind, und zum Ausgeben der Pixeldaten der Bildaufnahmeelemente (211), wobei der Bildsensor (2) in einer X-Achsenrichtung in Blockelementgruppen unterteilt ist, die jeweils die gleiche Anzahl (K) von Bildaufnahmeelementen (211) aufweisen, wobei der Bildsensor konfiguriert ist zum Sammeln einer fixen Anzahl (K) von Pixeldaten, die durch die entsprechenden Bildaufnahmeelemente (211) erhalten werden, zu einem Datenblock und zum Ausgeben der Pixeldaten für jeden Datenblock, und zum Ausgeben der Pixeldaten der Bildaufnahmeelemente (211) in Datenblöcken, wobei jeder Datenblock die Pixeldaten einer Blockelementgruppe von Bildaufnahmeelementen (211) enthält,
eine Interessanter-Bereich-Setzeinrichtung (3) zum Setzen eines interessanten Bereichs (RI), der ein Bildbereich ist, der kleiner als das gesamte Bild ist und durch einen Startpunkt-Grenzwert (XS1) und einen Endpunkt-Grenzwert (XE1) in der X-Achsenrichtung gesetzt wird,
eine Bereichserweiterungseinrichtung (4) zum Erweitern des interessanten Bereichs (RI), wenn der Startpunkt-Grenzwert (XS1) und der Endpunkt-Grenzwert (XE1) in der X-Achsenrichtung des interessanten Bereichs (RI) nicht mit den Grenzen der Blockelementgruppen übereinstimmen, wobei die Bereichserweiterungseinrichtung (4) den interessanten Bereich (RI) um Erweiterungsbereiche (Exs, Exe) in der X-Achsenrichtung erweitert, um einen erweiterten interessanten Bereich (RE) zu setzen, der den Grenzen der Blockelementgruppe entspricht,
eine Ausgabeeinrichtung (26) zum Ausgeben nur der Datenblöcke, die in dem erweiterten interessanten Bereich (RE) enthalten sind, von dem Bildsensor (2), und
eine Erweiterungsbereich-Löscheinrichtung (6) zum Löschen von Pixeldaten der Erweiterungsbereiche (Exs, Exe) aus den ausgegebenen Datenblöcken, um ein Bild des interessanten Bereichs (RI) zu erhalten.

7. Vorrichtung nach Anspruch 6, die weiterhin umfasst:
eine Bereichsoptimierungseinrichtung (7), die auf die Bereichserweiterungseinrichtung (14) folgend betrieben wird zum Wandeln einer Vielzahl von erweiterten interessanten Bereichen zu nicht-überlappenden Bereichen, die nicht miteinander überlappen, wenn eine Vielzahl von interessanten Bereichen durch die Interessanter-Bereich-Setzeinrichtung (3) gesetzt werden und einige aus der durch die Bereichserweiterungseinrichtung (4) erhaltenen Vielzahl von erweiterten interessanten Bereichen miteinander überlappen,
wobei die Ausgabeeinrichtung (26) Datenblöcke, die in den nicht-überlappenden Bereichen enthalten sind, anstatt der erweiterten interessanten Bereiche ausgibt.

8. Vorrichtung nach Anspruch 6, die weiterhin umfasst:
einen Multiplexer, der Blockelementgruppen, die durch das Teilen der Vielzahl von Bildaufnahmeelementen, die linear in der X-Achsenrichtung in einer Einheit mit einer fixen Anzahl angeordnet sind, erhalten werden, ändert und auswählt,
AD-Wandler (25) in einer der fixen Anzahl entsprechenden Anzahl, die Pixeldaten jedes Bildelements einer durch den Multiplexer ausgewählten Blockelementgruppe digitalisieren,
wobei die Interessanter-Bereich-Setzeinrichtung (3) einen rechtwinkligen interessanten Bereich parallel zu einer X-Achse und einer Y-Achse setzt,
wobei die Bereichserweiterungseinrichtung (4) den rechtwinkligen interessanten Bereich zu der X-Achsenrichtung erweitert, um einen rechtwinkligen erweiterten interessanten Bereich zu erhalten, und
wobei die Ausgabeeinrichtung (26) einen Y-Achsen-Koordinatenwert eines Abbildungselements, das ein anfängliches Ausgabeziel ist, bei einem minimalen Wert des erweiterten interessanten Bereichs fixiert, Ausgabepixeldaten jedes Bildelements einer Blockelementgruppe einer ersten Reihe unter Verwendung des AD-Wandlers (25) digitalisiert und ausgibt, einen Y-Achsen-Koordinatenwert eines Bildaufnahmeelements, das das nächste Ausgabeziel ist, um ein Bildaufnahmeelement zu einem bestimmten Wert erhöht und fixiert, Ausgabepixeldaten jedes Bildelements einer Blockelementgruppe einer zweiten Reihe unter Verwendung des AD-Wandlers (25) digitalisiert und ausgibt, und wiederholt Pixeldaten jedes Bildelements einer Blockelementgruppe jeder Reihe ausgibt, bis ein Y-Achsen-Koordinatenwert eines Bildaufnahmeelements, das das Ausgabeziel ist, ein maximaler Wert des erweiterten interessanten Bereichs wird, sodass alle Datenblöcke, die in dem rechtwinkligen erweiterten interessanten Bereich enthalten sind, ausgegeben werden.

9. Vorrichtung nach Anspruch 8, die weiterhin umfasst:
eine Bereichsoptimierungseinrichtung (7), die auf die Bereichserweiterungseinrichtung (4) folgend betrieben wird, zum Wandeln einer Vielzahl von rechtwinkligen erweiterten interessanten Bereichen zu rechtwinkligen nicht-überlappenden Bereichen, die nicht miteinander überlappen und nicht aufeinanderfolgend in der X-Achsenrichtung angeordnet sind, wenn eine Vielzahl von rechtwinkligen interessanten Bereichen durch die Interessanter-Bereich-Setzeinrichtung gesetzt werden und einige aus der durch die Bereichserweiterungseinrichtung erhaltenen Vielzahl von rechtwinkligen erweiterten interessanten Bereichen miteinander überlappen,
wobei die Ausgabeeinrichtung (26) alle Datenblöcke, die in den rechtwinkligen nicht-überlappenden Bereichen enthalten sind, anstatt der rechtwinkligen erweiterten interessanten Bereiche ausgibt.

10. Vorrichtung nach einem der Ansprüche 6 bis 9, wobei die Erweiterungsbereich-Löscheinrichtung (6) unter Verwendung eines feldprogrammierbaren Gate-Arrays gebildet wird.

## Revendications

1. Procédé pour sortir des données d'image d'un capteur d'images (2), le capteur d'images (2) étant configuré pour capturer une image en utilisant une pluralité d'éléments d'imagerie (211) agencés de manière bidimensionnelle sur des axes de coordonnées orthogonaux X-Y, le capteur d'images (2) étant divisé en direction de l'axe X en groupes d'éléments de bloc qui ont chacun le même nombre (K) d'éléments d'imagerie (211), le capteur d'images étant configuré pour collecter un nombre fixe (K) de données de pixel obtenues par les éléments d'imagerie respectifs (211) dans un bloc de données, et pour sortir les données de pixel des éléments d'imagerie (211) dans des blocs de données comprenant chacun les données de pixel d'un groupe d'éléments de bloc d'éléments d'imagerie (211), le procédé comprenant les étapes suivantes :
une étape d'imagerie (S6) consistant à mettre en oeuvre une imagerie avec le capteur d'images (2), et à obtenir des données de pixel provenant des éléments d'imagerie respectifs (211)
une étape d'établissement de région d'intérêt (S1) consistant à établir une région d'intérêt (RI) qui est une région d'image plus petite que l'image entière établie par une valeur de délimitation de point de départ (XS1) et une valeur de délimitation de point d'arrivée (XE1) en direction de l'axe X ;
une étape d'extension de région (S2) consistant à étendre la région d'intérêt (RI) quand la valeur de délimitation de point de départ (XS1) et la valeur de délimitation de point d'arrivée (XE1) en direction de l'axe X de la région d'intérêt (RI) ne correspondent pas aux délimitations des groupes d'éléments de bloc, l'étape d'extension de région (S2) étend la région d'intérêt (RI) par des plages d'extension (Exs, Exe) en direction de l'axe X de manière à établir une région d'intérêt étendue (RE) qui correspond aux délimitations du groupe d'éléments de bloc ;
l'étape d'imagerie (S6) obtient les données de pixel des éléments d'imagerie respectifs (211) dans la région d'intérêt étendue (RE) ;
une étape de sortie (S7) consistant à sortir uniquement les blocs de données inclus dans la région d'intérêt étendue (RE) par le capteur d'images (2) ; et
une étape d'effacement de plage d'extension (S8) consistant à effacer des données de pixel des plages d'extension (Exs, Exe) dans les blocs de données de sortie de manière à obtenir une image de la région d'intérêt.

2. Procédé selon la revendication 1, comprenant en outre : une étape d'optimisation de région (S4) consistant à convertir une pluralité de régions d'intérêt étendues dans des régions non chevauchantes qui ne se chevauchent pas mutuellement, subséquemment à l'étape d'extension de région (S2), quand une pluralité de régions d'intérêt sont établies à l'étape d'établissement de région de transmission (S1), et certaines régions de la pluralité de régions d'intérêt étendues obtenues à l'étape d'extension de région se chevauchent mutuellement,
dans lequel, à l'étape de sortie (S7), des blocs de données inclus dans les régions non chevauchantes sont sortis plutôt que les régions d'intérêt étendues.

3. Procédé selon la revendication 1,
dans lequel, à l'étape d'établissement de région de transmission (S1), est établie une région d'intérêt rectangulaire parallèle à un axe X et à un axe Y, dans lequel, à l'étape d'extension de région (S2), la région d'intérêt rectangulaire est étendue en direction de l'axe X de manière à obtenir une région d'intérêt étendue rectangulaire, et
dans lequel, à l'étape de sortie (S7), une valeur de coordonnée d'axe Y d'un élément d'imagerie (211) qui est une cible de sortie est fixée initialement à une valeur minimale de la région d'intérêt étendue, une valeur de coordonnée d'axe X est changée d'une valeur parmi la valeur minimale et une valeur maximale de la région d'intérêt étendue à l'autre valeur, de telle sorte qu'est sorti un bloc de données d'une première rangée, alors une valeur de coordonnée d'axe Y d'un élément d'imagerie (211) qui est la cible de sortie est augmentée d'un élément d'imagerie de manière à être fixée, une valeur de coordonnée d'axe X est changée d'une valeur parmi la valeur minimale et la valeur maximale de la région d'intérêt étendue à l'autre valeur de telle sorte qu'est sorti un bloc de données d'une deuxième rangée, et un bloc de données de chaque rangée est sorti de manière répétée jusqu'à ce qu'une valeur de coordonnée d'axe Y d'un élément d'imagerie qui est la cible de sortie devienne une valeur maximale de la région d'intérêt étendue de telle sorte que sont sortis tous les blocs de données inclus dans la région d'intérêt étendue rectangulaire.

4. Procédé selon la revendication 3, comprenant en outre :
une étape d'optimisation de région (S4) consistant à convertir une pluralité de régions d'intérêt étendues rectangulaires en régions non chevauchantes rectangulaires qui ne se chevauchent pas mutuellement et ne sont pas situées de manière continue en direction de l'axe X, subséquemment à l'étape d'extension de région, quand une pluralité de régions d'intérêt rectangulaires sont établies à l'étape d'établissement de région de transmission (S1), et certaines régions de la pluralité de régions d'intérêt étendues rectangulaires obtenues à l'étape d'extension de région se chevauchent mutuellement,
dans lequel, à l'étape de sortie (S7), tous les blocs de données inclus dans les régions non chevauchantes rectangulaires sont sortis plutôt que les régions d'intérêt étendues rectangulaires (RE).

5. Procédé selon la revendication 4,
dans lequel l'étape d'optimisation de région (S4) comprend : une sous-étape de subdivision de région (Ss1) consistant à subdiviser la région d'imagerie en une pluralité de petites régions avec une forme de treillis en utilisant toutes les valeurs de coordonnée d'axe X et des valeurs de coordonnée d'axe Y indiquant les délimitations de la pluralité de régions d'intérêt étendues rectangulaires ;
une sous-étape de tri de région (Ss2) consistant à trier chacune des petites régions en une petite région nécessaire à l'intérieur de la région d'intérêt étendue et une petite région non nécessaire à l'extérieur de la région d'intérêt étendue ;
une sous-étape de connexion en direction de l'axe X (Ss3) consistant à connecter une pluralité de petites régions nécessaires qui sont situées de manière continue en direction de l'axe X de manière à remplacer la pluralité de petites régions nécessaires par de nouvelles petites régions nécessaires ;
une sous-étape de connexion en direction de l'axe Y (Ss4) consistant à connecter une pluralité de petites régions nécessaires qui sont situées de manière continue en direction de l'axe Y et comportent les mêmes valeurs de coordonnée d'axe X indiquant les délimitations de manière à remplacer la pluralité de petites régions nécessaires par de nouvelles petites régions nécessaires ; et
une sous-étape de fixation de région (Ss5) consistant à utiliser les petites régions nécessaires obtenues après que la sous-étape de connexion en direction de l'axe X et la sous-étape de connexion en direction de l'axe Y sont terminées, comme régions non chevauchantes rectangulaires.

6. Appareil pour sortir des données d'image d'un capteur d'images (2), comprenant :
un capteur d'images (2) qui est configuré pour capturer une image en utilisant une pluralité d'éléments d'imagerie (211) agencés de manière bidimensionnelle sur des axes de coordonnées orthogonaux X-Y, et pour sortir les données de pixel des éléments d'imagerie (211), le capteur d'images (2) est divisé en direction de l'axe X en groupes d'éléments de bloc qui ont chacun le même nombre (K) d'éléments d'imagerie (211), le capteur d'images étant configuré pour collecter un nombre fixe (K) de données de pixel obtenues par les éléments d'imagerie respectifs (211) dans un bloc de données, et pour sortir les données de pixel pour chaque bloc de données, et pour sortir les données de pixel des éléments d'imagerie (211) dans des blocs de données, chaque bloc de données comprenant les données de pixel d'un groupe d'éléments de bloc d'éléments d'imagerie (211) ;
un moyen d'établissement de région d'intérêt (3) pour établir une région d'intérêt (RI) qui est une région d'image plus petite que l'image entière établie par une valeur de délimitation de point de départ (XS1) et une valeur de délimitation de point d'arrivée (XE1) en direction de l'axe X ;
un moyen d'extension de région (4) pour étendre la région d'intérêt (RI) quand la valeur de délimitation de point de départ (XS1) et la valeur de délimitation de point d'arrivée (XE1) en direction de l'axe X de la région d'intérêt (RI) ne correspondent pas aux délimitations des groupes d'éléments de bloc, le moyen d'extension de région (4) étend la région d'intérêt (RI) par des plages d'extension (Exs, Exe) en direction de l'axe X de manière à établir une région d'intérêt étendue (RE) qui correspond aux délimitations des groupes d'éléments de bloc ;
un moyen de sortie (26) pour sortir uniquement les blocs de données inclus dans la région d'intérêt étendue (RE) depuis le capteur d'images (2) ; et
un moyen d'effacement de région d'extension (6) pour effacer des données de pixel des plages d'extension (Exs, Exe) des blocs de données sortis, de manière à obtenir une image de la région d'intérêt (RI).

7. Appareil selon la revendication 6, comprenant en outre :
un moyen d'optimisation de région (7), utilisé subséquemment au moyen d'extension de région (14), pour convertir une pluralité de régions d'intérêt étendues dans des régions non chevauchantes qui ne se chevauchent pas mutuellement, quand une pluralité de régions d'intérêt sont établies par le moyen d'établissement de région de transmission (3), et certaines régions de la pluralité de régions d'intérêt étendues obtenues par le moyen d'extension de région (4) se chevauchent mutuellement,
dans lequel le moyen de sortie (26) sort des blocs de données inclus dans les régions non chevauchantes plutôt que les régions d'intérêt étendues.

8. Appareil selon la revendication 6, comprenant en outre
un multiplexeur qui change et sélectionne des groupes d'éléments de bloc obtenus en divisant la pluralité d'éléments d'imagerie qui sont agencés de manière linéaire en direction de l'axe X dans une unité du nombre fixe ; et
des convertisseurs analogique-numérique (25), avec le même nombre que le nombre fixe, qui numérisent des données de pixel de chaque élément d'image d'un groupe d'éléments de bloc sélectionné par le multiplexeur,
dans lequel le moyen d'établissement de région de transmission (3) établit une région d'intérêt rectangulaire parallèle à un axe X et à un axe Y,
dans lequel le moyen d'extension de région (4) étend la région d'intérêt rectangulaire en direction de l'axe X de manière à obtenir une région d'intérêt étendue rectangulaire, et
dans lequel le moyen de sortie (26) fixe une valeur de coordonnée d'axe Y d'un élément d'imagerie qui est une cible de sortie initiale à une valeur minimale de la région d'intérêt étendue, numérise et sort des données de pixel de chaque élément d'image d'un groupe d'éléments de bloc d'une première rangée en utilisant le convertisseur analogique-numérique (25), augmente et fixe une valeur de coordonnée d'axe Y d'un élément d'imagerie qui est la cible de sortie suivante d'un élément d'imagerie à une certaine valeur, numérise et sort des données de pixel de chaque élément d'image d'un groupe d'éléments de bloc d'une deuxième rangée en utilisant le convertisseur analogique-numérique (25), et sort de manière répétée des données de pixel de chaque élément d'image d'un groupe d'éléments de bloc de chaque rangée jusqu'à ce qu'une valeur de coordonnée d'axe Y d'un élément d'imagerie qui est la cible de sortie devienne une valeur maximale de la région d'intérêt étendue de telle sorte que sont sortis tous les blocs de données inclus dans la région d'intérêt étendue rectangulaire.

9. Appareil selon la revendication 8, comprenant en outre :
un moyen d'optimisation de région (7), utilisé subséquemment au moyen d'extension de région (4), pour convertir une pluralité de régions d'intérêt étendues rectangulaires en des régions non chevauchantes rectangulaires qui ne se chevauchent pas mutuellement et qui ne sont pas situées de manière continue en direction de l'axe X, quand une pluralité de régions d'intérêt rectangulaires sont établies par le moyen d'établissement de région de transmission, et certaines régions de la pluralité de régions d'intérêt étendues rectangulaires obtenues par le moyen d'extension de région se chevauchent mutuellement,
dans lequel le moyen de sortie (26) sort tous les blocs de données inclus dans les régions non chevauchantes rectangulaires plutôt que les régions d'intérêt étendues rectangulaires.

10. Appareil selon l'une quelconque des revendications 6 à 9, dans lequel le moyen d'effacement de région d'extension (6) est constitué en utilisant un réseau de portes programmables in situ.
